# EUROPÄISCHE PATENTANMELDUNG

(11) **EP 1 983 570 A2**
(43) Veröffentlichungstag der Anmeldung: **22.10.2008**
(21) Anmeldenummer: 08161487.7
(22) Anmeldetag: 14.08.2003
(51) Int. Cl.: H01L 23/522, G06F 17/50, H01L 23/532

(54) **Integrierte Schaltungsanordnung mit Zwischenmaterialien und zugehörige Komponenten**

(30) Priorität: 05.09.2002 DE 10241154
(62) Teilanmeldung aus: 03794790.0
(71) Anmelder: Infineon Technologies AG, 85579 Neubiberg (DE)
(72) Erfinder: Fischer, Armin, 81825 München (DE); Glasow von, Alexander, 82031 Grünwald (DE)
(74) Vertreter: Karl, Frank

(57) **Zusammenfassung**

Erläutert wird unter anderem eine integrierte Schaltungsanordnung, in der sich Via-Liner (28) und Leitbahn-Liner (20) berühren. Durch diese Berührung werden die elektrischen Eigenschaften, insbesondere die Lebensdauer bzw. Zuverlässigkeit, der integrierten Schaltungsanordnung (10) verbessert.

## Beschreibung

Die Erfindung betrifft eine integrierte Schaltungsanordnung, die mindestens eine Metallisierungslage enthält. In der Metallisierungslage sind eine Vielzahl elektrisch leitender Leitbahnen, beispielsweise aus Kupfer oder aus Aluminium, angeordnet. Zwischen den Leitbahnen der Metallisierungslage ist ein Leitbahndielektrikum angeordnet, beispielsweise Siliziumdioxid oder ein Material mit einer Dielektrizitätskonstante deutlich kleiner als Vier. Zwischen einer quer zur Metallisierungslage in der Metallisierungslage liegenden Seitenfläche einer Leitbahn und dem Leitbahndielektrikum ist jeweils ein elektrisch leitfähiges Leitbahn-Zwischenmaterial angeordnet, das sich vom Material der Leitbahn unterscheidet.

Die integrierte Schaltungsanordnung enthält außerdem eine Vielzahl elektrisch leitender Verbindungsabschnitte, bspw. sogenannte Vias, die jeweils einen der Leitbahn benachbarten Abschnitt einer elektrisch leitfähigen Verbindung zu oder von einer Leitbahn bilden. Beispielsweise bestehen die Verbindungsabschnitte aus Wolfram oder Kupfer. Zwischen den Verbindungsabschnitten ist ein Verbindungsabschnittsdielektrikum angeordnet, das beispielsweise die gleiche Materialzusammensetzung wie das Leitbahndielektrikum hat. Zwischen einem Verbindungsabschnitt und dem Verbindungsabschnittsdielektrikum und/oder zwischen einem Verbindungsabschnitt und einer Leitbahn ist ein Verbindungsabschnitt-Zwischenmaterial angeordnet.

Die Zwischenmaterialien werden u.a. auch als Liner bezeichnet und erfüllen beispielsweise mindestens eine der folgenden Funktionen:
- Bildung einer metallurgischen Barriereschicht,
- Bildung einer Diffusionsbarriere,
- Erhöhung der Haftkraft der Leitbahn bzw. des Verbindungsabschnittes im Dielektrikum,
- Ausgleich von Materialspannungen.

Geeignete Materialien für das Zwischenmaterial sind beispielsweise die Refraktärmetalle Molybdän, Wolfram, Tantal und Titan. Insbesondere werden aber auch die Nitride dieser Metalle als Zwischenmaterial eingesetzt, gegebenenfalls auch in Doppel- oder Mehrfachschichten, z.B. Titan/Titannitrid.

Es ist Aufgabe der Erfindung, eine einfach aufgebaute integrierte Schaltungsanordnung anzugeben, die im Vergleich zu bekannten Schaltungsanordnungen verbesserte elektrische Eigenschaften hat, insbesondere eine erhöhte Zuverlässigkeit und/oder Lebensdauer. Außerdem sollen ein zugehöriges Verfahren zum Erzeugen von Entwurfsdaten für die Herstellung dieser Schaltungsanordnung, ein zugehöriges Programm und eine zugehörige Datenverarbeitungsanlage angegeben werden.

Die auf die Schaltungsanordnung bezogene Aufgabe wird durch eine Schaltungsanordnung mit den im Patentanspruch 1 angegebenen Merkmalen gelöst. Weiterbildungen sind in den Unteransprüchen angegeben.

Die Erfindung geht von der Überlegung aus, dass die Beständigkeit des Verbindungsabschnitts-Leitbahn-Systems gegen Elektromigration aber auch gegen Stressmigration und Temperaturzyklen Robustheit sehr stark von der Anordnung der Zwischenmaterialien zueinander abhängen. Ist beispielsweise das Verbindungsabschnitts-Zwischenmaterial mit Abstand zum Leitbahn-Zwischenmaterial angeordnet, so gibt es keine Redundanz durch das Zwischenmaterial bei der Leitung des Stromes. Im Fall einer Lochbildung (Void) im Bereich des Kontaktes von Verbindungsabschnitt und Leitbahn durch Elektro- oder auch Stressmigration steht das Zwischenmaterial nicht als redundanter Strompfad zur Verfügung. Folglich führen bereits kleine Leerstellen-Volumen zu einem großen Widerstandsanstieg des Kontaktwiderstandes zwischen Leitbahn und Verbindungsabschnitt und können die Funktion der integrierten Schaltung erheblich beeinträchtigen. Sogar der Ausfall der Schaltungsanordnung ist möglich.

Deshalb berührt bei der erfindungsgemäßen Schaltungsanordnung an mindestens einer Verbindung das Leitbahn-Zwischenmaterial das Verbindungsabschnitts-Zwischenmaterial bspw. an einer Kante der Leitbahn. Durch die Berührung der Zwischenmaterialien wird eine Strompfadredundanz erzeugt, die selbst bei gleichbleibender Elektromigration einen längeren Betrieb der integrierten Schaltungsanordnung ermöglicht.

Bei einer Weiterbildung der Schaltungsanordnung berührt das Leitbahn-Zwischenmaterial an der Verbindung das Verbindungsabschnitt-Zwischenmaterial an zwei, drei oder vier Seitenflächen bzw. Kanten einer Leitbahn. An Leitbahnen, an denen der Verbindungsabschnitt bzw. das Via an zwei, drei oder vier Seitenflächen bzw. Kanten mit dem Leitbahn-Zwischenmaterial verbunden ist, ist die Stromleitfähigkeit deutlich höher als im Vergleich zu Anordnungen ohne Berührungsstelle oder mit nur einer Berührungsstelle bzw. einem kleinen Berührungsbereich von Verbindungsabschnitt-Zwischenmaterial und Leitbahn-Material. Ursache dafür ist die "Barriere-Redundanz". Selbst bei einsetzender Bildung von Leerstellen unter oder über dem Verbindungsabschnitt durch Elektro- oder Stressmigration fließt der Strom noch über das elektrisch leitende Zwischenmaterial. Ein beachtlicher Widerstandsanstieg, der eine Funktionsstörung oder den Ausfall der Schaltungsanordnung zur Folge hat, tritt erst bei einem vergleichsweise großen Leerstellenvolumen ein, d.h. bei einer entsprechend höheren Strombelastung oder einer längeren Betriebsdauer im Vergleich zu Strukturen ohne oder mit einer verminderten Zwischenmaterial-Redundanz.

Die Berührung von zwei Seitenflächen bzw. Kanten lässt sich erreichen, wenn die Verbindungsanordnung in einer Ecke einer Deckfläche bzw. einer ansonsten linerfreien Bodenfläche der Leitbahn angeordnet wird oder wenn die Leitbahn und der Verbindungsabschnitt in lateraler Richtung etwa die gleiche Ausdehnung haben. Das Berühren von drei Seitenflächen bzw. Kanten wird ermöglicht, wenn der Verbindungsabschnitt und die Leitbahn in lateraler Richtung die gleiche Ausdehnung haben und wenn der Verbindungsabschnitt am Ende der Leitbahn angeordnet wird. Ein Berühren von vier Seitenflächen bzw. Kanten ist dann möglich, wenn der Verbindungsabschnitt und die Leitbahn in zwei zueinander rechtwinklige Richtungen jeweils gleiche Abmessungen haben. Solche Abmessungen sind beispielsweise bei übereinander gestapelten Verbindungsabschnitten sinnvoll, die mehrere Metallisierungslagen durchdringen. In jeder Metallisierungslage gibt es zur Verbindung der Verbindungsabschnitte sogenannte Anschlussplatten mit einer quadratischen oder rechteckigen Grundfläche.

Bei einer nächsten Weiterbildung hat die Leitbahn am Verbindungsabschnitt eine Einschnürung, deren Breite bei einer Ausgestaltung so gewählt ist, dass an gegenüberliegenden Seitenflächen der Leitbahn Berührungsbereiche entstehen. Die Einschnürung lässt sich im Vergleich zur Gesamtlänge einer Leitbahn vergleichsweise kurz bemessen. So hat die Einschnürung bei einer Ausgestaltung entlang der Längsachse der Leitbahn eine Länge, die kleiner als das Fünffache oder sogar kleiner als das Dreifache der Breite der Einschnürung an ihrer schmalsten Stelle ist. Das Verwenden von Einschnürungen ist eine einfache Möglichkeit, um die Anzahl von Berührungsbereichen der Zwischenmaterialien zu erhöhen.

Bei einer Weiterbildung der Schaltungsanordnung mit Einschnürung ist der Verbindungsabschnitt am Ende der Leitbahn angeordnet. Die Einschnürung hat die Form eines Keils oder die Form einer Stufe.

Bei einer alternativen Weiterbildung der Schaltungsanordnung mit Einschnürung erstreckt sich die Leitbahn vom Verbindungsabschnitt aus in mindestens zwei verschiedene Richtungen. Die Einschnürung hat an ihren Enden jeweils die Form eines Keils oder die Form einer Stufe. Bei Einschnürungen innerhalb einer Leitbahn ist besonders auf sekundäre Effekte zu achten, wie z.B. eine Strombündelung. Um bei der durch die Einschnürung unvermeidbaren Strombündelung lokale Stromspitzen zu vermeiden, wird die Leitbahn nicht abrupt in Winkeln von beispielsweise neunzig Grad eingeschnürt, sondern allmählich.

Bei einer nächsten Weiterbildung sind mindestens zwei Abschnitte derselben Leitbahn oder verschiedener Leitbahnen an Verbindungsabschnitten breiter als die Verbindungsabschnitte. Die Berührungsbereiche der Zwischenmaterialien liegen an solchen Seitenflächen der Leitbahnabschnitte, deren Normalenrichtung quer oder entgegengesetzt zueinander liegen. Dies erfordert es, die Verbindungsabschnitte gezielt an Seitenflächen mit voneinander verschiedener Normalenrichtung anzuordnen.

Die Erfindung betrifft in einem weiteren Aspekt ein Verfahren zum Erzeugen von Entwurfsdaten für die Herstellung integrierter Schaltungsanordnungen, insbesondere der erfindungsgemäßen Schaltungsanordnung oder einer ihrer Weiterbildungen. Bei dem erfindungsgemäßen Verfahren werden Entwurfsdaten und Regeln zum Verändern der Entwurfsdaten vorgegeben. Ein automatisches Anwenden der Regeln auf die Entwurfsdaten hat zur Folge, dass die Anzahl der Berührungsstellen von Leitbahn-Zwischenmaterial und Verbindungsabschnitts-Zwischenmaterial gezielt erhöht wird. Durch das automatische Anwenden der Regeln lässt sich der Entwurf an einer Vielzahl von Verbindungsabschnitten in sehr kurzer Zeit prüfen und gegebenenfalls verändern. Gegebenenfalls ist nur eine stichprobenhafte Kontrolle durch erfahrenes Entwicklungspersonal erforderlich.

Bei einer Weiterbildung des Verfahrens sind in den Regeln zwei grundsätzliche Varianten hinterlegt, die Anzahl von Berührungsstellen zu erhöhen, nämlich:
- lokales Einschnüren von Leitbahnen, und
- Versetzen von Leitbahnen bzw. Verbindungsabschnitten, wobei ein Versetzen von Leitbahnen bei einer Ausgestaltung auch ein Verkürzen der Leitbahn enthält.

Die Erfindung betrifft außerdem ein Programm und eine Vorrichtung, insbesondere eine Datenverarbeitungsanlage, die zur Durchführung des erfindungsgemäßen Verfahrens oder einer seiner Weiterbildungen geeignet sind. Damit gelten die oben genannten technischen Wirkungen auch für das Verfahren, für das Programm und für die Vorrichtung.

Im Folgenden werden Ausführungsbeispiele der Erfindung an Hand der Zeichnungen erläutert. Darin zeigen:
- Figur 1: ein Via und eine Leitbahn ohne Berührungsstelle zwischen dem Liner der Leitbahn und dem Liner des Vias,
- Figuren 2A bis 2C: das Erzeugen von lokalen Einschnürungen innerhalb einer Leitbahn in einem Entwurf,
- Figuren 3A bis 3C: das Erzeugen von lokalen Einschnürungen am Ende einer Leitbahn in einem Entwurf,
- Figuren 4A und 4B: das Versetzen eines Vias an den Rand einer Leitbahn in einem Entwurf,
- Figuren 5A bis 5C: das Versetzen eines Vias an eine Stirnkante einer Leitbahn bzw. in eine Ecke einer Leitbahndeckfläche in einem Entwurf,
- Figuren 6A und 6B: das Versetzten eines Vias mit gleicher Breite wie eine Leitbahn an das Ende der Leitbahn in einem Entwurf,
- Figur 7: einen Entwurf für eine Anordnung mit vierfacher Linerberührung,
- Figur 8: Verfahrensschritte zum gezielten Erhöhen der Berührungsstellen von Linern, und
- Figur 9: eine Vorrichtung zum Ausführen des Verfahrens.

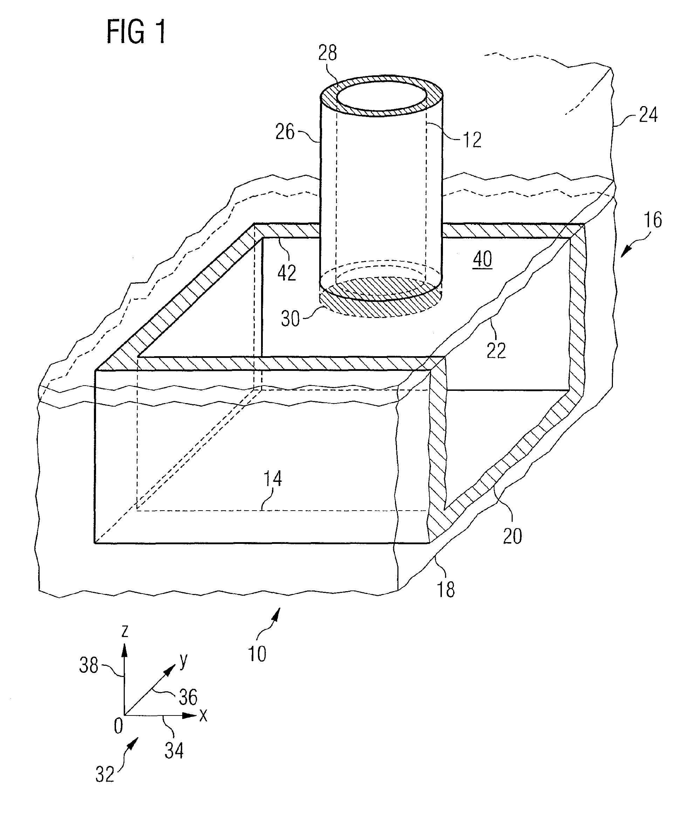

Figur 1 zeigt einen Ausschnitt aus einer integrierten Schaltungsanordnung 10, die ein Via 12 und eine Leitbahn 14 enthält. Zu der integrierten Schaltungsanordnung 10 gehören Entwurfsdaten, die noch nicht mit Hilfe eines Verfahrens zum gezielten Erhöhen der Anzahl von Berührungsstellen von Linern bearbeitet worden sind.

Die integrierte Schaltungsanordnung 10 enthält eine Metallisierungslage 16, die sich im Wesentlichen in einer Ebene erstreckt, die parallel zu der Oberfläche eines nicht dargestellten Halbleitersubstrats liegt, in dem eine Vielzahl integrierter Halbleiterbauelemente angeordnet sind, z.B. FET-Transistoren (Field Effect Transistor). In der Metallisierungslage 16 sind neben der Leitbahn 14 eine Vielzahl von anderen, nicht dargestellten, Leitbahnen enthalten, die voneinander durch ein Dielektrikum 18 getrennt sind, beispielsweise durch Siliziumdioxid. Im Ausführungsbeispiel bestehen die Leitbahnen 14 der Metallisierungslage 16 aus Kupfer.

Die Metallisierungslage 14 wurde mit Hilfe eines sogenannten Damascene- bzw. eines Dualen-Damasceneverfahrens hergestellt. Bei diesem Verfahren werden in der angegebenen Reihenfolge die folgenden Schritte ausgeführt:
- das Dielektrikum 18 wird abgeschieden,
- Gräben für die Leitbahnen 14 werden geätzt,
- eine Leitbahn-Linerschicht wird abgeschieden, durch die beispielsweise ein Leitbahn-Liner 20 für die Leitbahn 14 am Boden und an den quer in der Metallisierungslage 16 liegenden Seitenflächen der Gräben für die Leitbahn 14 und damit später auch am Boden und den quer zur Metallisierungslage 16 liegenden Seitenflächen der Leitbahn 14 entsteht. Die Leitbahn-Linerschicht hat beispielsweise eine Dicke von 5 nm, von 15 nm oder von 20 nm,
- die Gräben für die Leitbahnen 14 werden mit dem Leitbahnmaterial gefüllt, und
- mit einem chemisch-mechanischen-Polierverfahren wird das Füllmaterial und das Linermaterial oberhalb der Grabenkanten wieder abgetragen, wobei planarisiert wird.

Die Metallisierungslage 16 wird von einer dielektrischen Zwischenschicht 22, beispielsweise aus Siliziumnitrid bedeckt. Oberhalb der dielektrischen Zwischenschicht 22 befindet sich eine dielektrische Schicht 24 bspw. aus Siliziumdioxid, in der eine Vielzahl von Vias angeordnet sind, beispielsweise das Via 12.

Bei der Herstellung des Via 12 und der anderen Vias wurden zunächst Kontaktlöcher 26 in die dielektrische Schicht 24 und die dielektrische Zwischenschicht 22 geätzt. Damit gibt es an einer der Bodenfläche der Leitbahn 14 abgewandten Deckfläche keinen Leitbahn-Liner 20. Anschließend wurde eine Via-Linerschicht abgeschieden, wobei beispielsweise ein Via-Liner 28 im Kontaktloch 26 abgeschieden worden ist. Der Via-Liner 28 bedeckt auch den Boden 30 des Kontaktlochs 26. Der Boden 30 des Kontaktlochs 26 liegt unmittelbar auf einer Deckfläche der Leitbahn 14 auf oder dringt etwas in die Leitbahn 14 ein. Beispielsweise hat der Via-Liner 28 die gleiche Dicke wie der Leitbahn-Liner 20. Im Ausführungsbeispiel ist das LinerMaterial für den Leitbahn-Liner 20 und für den Via-Liner 28 Titannitrid.

Nach der Abscheidung des Via-Liners 28 wurden die Kontaktlöcher 26 beispielsweise mit Wolfram oder Kupfer gefüllt, wobei das Via 12 erzeugt worden ist. Oberhalb der dielektrischen Schicht 24 befinden sich im Ausführungsbeispiel noch weitere Metallisierungslagen.

In Figur 1 ist außerdem ein Koordinatensystem 32 dargestellt, das eine x-Achse 34, eine y-Achse 36 und eine z-Achse 38 hat. Die x-y-Ebene liegt parallel zu den Ebenen, in denen die Metallisierungslage 16, die dielektrische Zwischenschicht 22 und die dielektrische Schicht 24 liegen. Die z-Richtung stimmt mit der Richtung überein, in der die Metallisierungslage 16, die dielektrische Zwischenschicht 22 und die dielektrische Schicht 24 übereinander gestapelt sind. Damit stimmt die z-Richtung mit der Richtung einer Normalen der Oberfläche des Halbleitersubstrats überein.

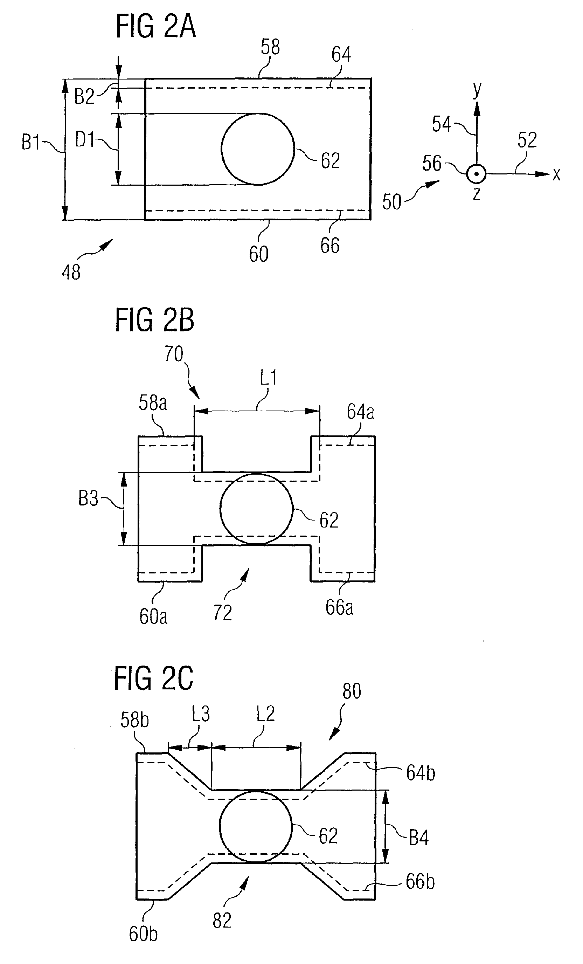

Wie in Figur 1 aufgrund einer Schraffur von Randflächen des Leitbahn-Liners 20 und des Via-Liners 28 gut zu erkennen ist, berühren sich Leitbahn-Liner 20 und Via-Liner 28 nicht. Jedoch ist es möglich, solche Berührungsstellen bei einer abgesehen von dem Via-Liner linerfreien Deckfläche der Leitbahn 14 durch das gezielte Verändern der Entwurfsdaten und einen auf den geänderten Entwurfsdaten beruhenden Herstellungsprozess zu erzeugen. Beispielsweise lässt sich das Via 12 in y-Richtung an die Oberkante einer hinteren Seitenfläche 40 der Leitbahn 14 versetzen, so dass es eine Berührungsstelle an einer Kante 42 der Leitbahn 14 gibt. Diese und andere Möglichkeiten zum Erzeugen von Berührungsstellen werden im Folgenden an Hand der Figuren 2A bis 7 näher erläutert.

Figur 2A zeigt eine Draufsicht auf zwei Ebenen eines Entwurfs 48 für die Muster bzw. Strukturen zweier Masken zur Herstellung einer integrierten Schaltungsanordnung und damit letztlich auch für Strukturen in zwei Ebenen der integrierten Schaltungsanordnung selbst. Ein Koordinatensystem 50 bildet den Bezug für Entwurfsdaten zum Festlegen der Entwürfe und gilt für die Entwürfe der Figuren 2A bis 3C. Das Koordinatensystem 50 hat eine x-Achse 52, eine y-Achse 54 und eine z-Achse 56. Die Entwürfe liegen jeweils in einer x-y-Ebene. Damit hat das Koordinatensystem 50 bzgl. der Entwürfe die gleiche Lage wie das Koordinatensystem 32 bezüglich der integrierten Schaltungsanordnung 10.

Eine Entwurfsebene für die Lage von Maskenmustern zur Erzeugung von Leitbahngräben in einer Metallisierungslage liegt entgegen der z-Richtung unter einer Entwurfsebene für die Lage von Maskenmustern zur Erzeugung von Kontaktlöchern für Vias. Die Lage von Ränder der Gräben wird mit Hilfe von Geraden bzw. Linien in der unteren Entwurfsebene vorgegeben. Die Lage der Ränder von Kontaktlöchern wird durch Kreise in der oberen Entwurfsebene vorgegeben, siehe beispielsweise die Geraden 58 und 60 zum Vorgeben der Lage des Randes einer Leitbahn und einen Kreis 62 zum Vorgeben der Lage eines zu der Leitbahn führenden Kontaktloches. Eine Breite B1 zwischen den parallel zueinander verlaufenden Geraden 58 und 60 legt unter Beachtung eines Skalierungsfaktors die Breite eines Grabens für die Leitbahn fest. Ein Durchmesser D1 des Kreises 62 legt unter Beachtung des Skalierungsfaktors den Durchmesser des Kontaktloches fest. Die Breite B1 ist in dem Entwurf etwa doppelt so groß wie der Durchmesser D1. Der Kreis 62 ist zwischen den beiden Geraden 60 und 58 zentriert. In Figur 2A ist außerdem eine Breite B2 dargestellt, die unter Beachtung des Skalierungsfaktors der Breite des Leitbahn-Liners entspricht. Die Breite B2 beträgt beispielsweise ein Zehntel der Breite B1. Gestrichelte Linien 64 und 66 geben die Lage des Innenrandes des Leitbahn-Liners bzgl. des Entwurfs 48 an.

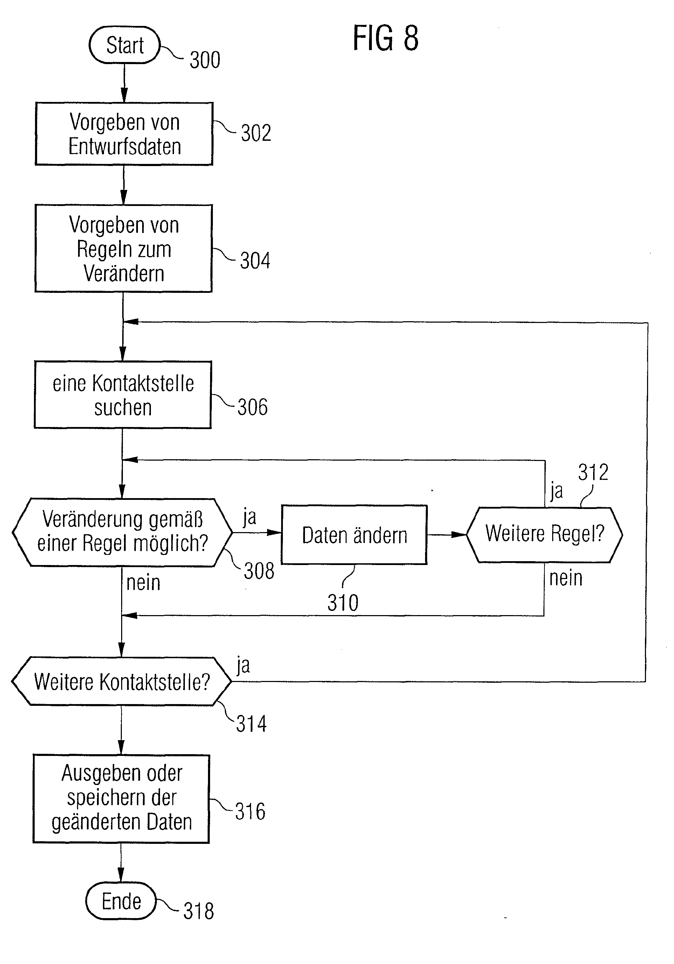

Figur 2B zeigt einen Entwurf 70, der aus dem an Hand der Figur 2A erläuterten Entwurf mit Hilfe eines unten an Hand der Figur 8 näher erläuterten Verfahrens automatisch erzeugt worden ist. Im Entwurf 70 gibt es eine Einengung 72 an den Geraden 58 und 60 entsprechenden Linien 58a und 60a. Die Einengung 72 befindet sich unterhalb des Kreises 62, dessen Lage und Durchmesser D1 unverändert geblieben ist. An den Enden der Einengung 72 befinden sich Stufen. Die Einengung 72 hat eine Länge L1, die etwa doppelt so groß wie der Durchmesser D1 des Kreises 62 ist. Entlang der gesamten Länge L1 hat die Einengung 72 eine gleichbeleibende Breite B3. Die Breite B3 der Einengung 72 ist gleich dem Durchmesser D1. Bei einem anderen Ausführungsbeispiel ist die Breite B3 sogar kleiner als der Durchmesser D1. Der Kreis 62 liegt zu den Stufen am Ende der Einengung 72 zentriert. Damit kommt es in Bereichen, die im integrierten Schaltkreis später die gleiche Lage haben, wie Überlappungsbereiche zwischen dem Kreis 62 und dem Zwischenraum zwischen den Linien 58a und 64a bzw. zwischen den Linien 60a und 66a zu einer Berührung des Leitbahn-Liners und des Via-Liners. Die gestrichelten Linien 64a und 66a entsprechen den gestrichelten Geraden 64 und 66 und geben die Lage des Leitbahn-Liners bzgl. des Entwurfs 70 an.

Figur 2C zeigt eine alternative Veränderung der Entwurfsdaten gemäß Figur 2A, wobei in einem Entwurf 80 eine Einengung 82 mit keilförmig verlaufenden Enden erzeugt worden ist. Die Lage und der Durchmesser des Kreises 62 sind unverändert geblieben. Jedoch wurde die Lage der Linien 58 und 60 mit Hilfe von einfachen geometrischen Berechnungen so geändert, dass Linien 58b und 60b erzeugt worden sind, die die Einengung 82 bilden. Außerhalb der Einengung 82 stimmt der Verlauf der Linien 58b und 60b mit dem Verlauf der Linien 58 und 60 überein. Im Bereich der Einengung 82 nähern sich die Linien 58b und 60b zunächst kontinuierlich aneinander an innerhalb einer Länge L3, die etwas kleiner als der Durchmesser D1 des Kreises 62 ist. Ist beispielsweise die Leitbahn mehr als drei mal so breit, wie der Durchmesser des Vias, so ist bei einem anderen Ausführungsbeispiel die Länge L3 größer als D1.

Haben die Linien 58b und 60b einen Abstand zueinander erreicht, der einer Breite B4 mit dem gleichen Wert wie der Durchmesser D1 des Kreises 62 entspricht, so verlaufen die Linien 58b und 60b für eine Länge L2 parallel zueinander. Die Länge L2 hat einen Wert, der etwa das Eineinhalbfache des Wertes des Durchmessers D1 ist. Anschließend laufen die Linien 58b und 60b wieder innerhalb einer Länge L3 auseinander. Aufgrund der Einengung 82 entstehen wiederum Überlappungsbereiche zwischen dem Kreis 62 und dem Zwischenraum zwischen der Linie 58b und einer gestrichelten Linie 64b bzw. zwischen der Linie 60B und einer gestrichelten Linie 66b. Die gestrichelten Linien 64b und 66b stellen die Lage das Leitbahn-Liners bezogen auf den Entwurf 80 dar.

Durch den in Figur 2C dargestellten Entwurf wird bei der entwickelten Schaltungsanordnung eine günstigere Strombündelung im Bereich einer der Einengung 82 entsprechenden Einengung der Leitbahn erzeugt. Bei einem alternativen Ausführungsbeispiel ändern die Linien 58b und 60b ihre Richtung nicht sprunghaft sondern kontinuierlich, so dass eine noch günstigere Stromverteilung erreicht wird.

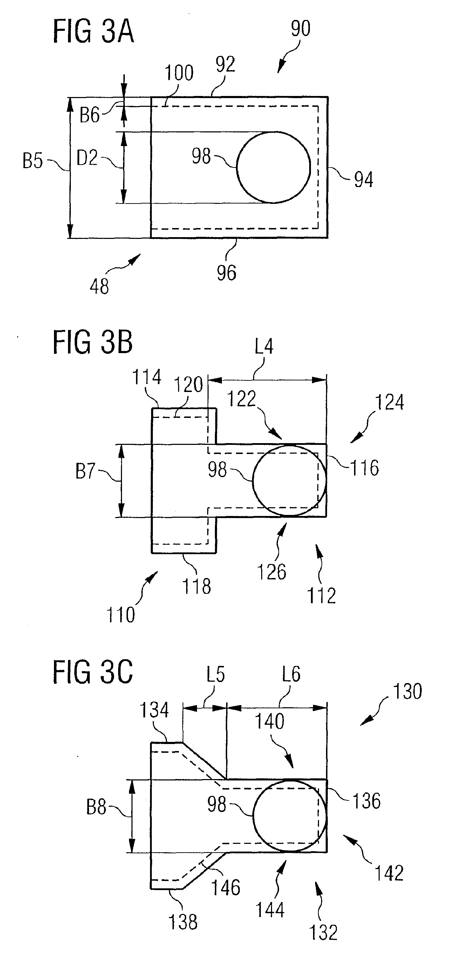

Figur 3A zeigt einen Entwurf 90 mit U-förmig angeordneten Geraden 92, 94 und 96 in einer ersten Entwurfsebene und mit einem den von den Geraden 92 bis 96 umgebenen Bereich überlappenden Kreis 98. Die Geraden 92 bis 96 legen letztlich die Lage der Ränder von Gräben für eine Leitbahn fest. Der Kreis 98 legt letztlich die Lage eines Kontaktloches fest, das zu der Leitbahn führt. Eine Breite B5 zwischen zwei parallel zueinander verlaufenden Geraden 92 und 96 legt unter Beachtung des Skalierungsfaktors die Breite des Grabens fest. Der Durchmesser D2 des Kreises 98 legt unter Beachtung des Skalierungsfaktors den Durchmesser des Kontaktloches fest. Die Breite B5 ist etwa doppelt so groß wie der Durchmesser D2. Eine gestrichelte Linie 100 dient der Darstellung der Lage des inneren Randes der Leitbahn-Linerschicht. Die Linie 100 hat zur Linie 92, 94 bzw. 96 einen Abstand B6, der bspw. etwa ein Zehntel der Breite B5 beträgt.

Figur 3B zeigt einen Entwurf 110, der mit Hilfe des unten an Hand der Figur 8 erläuterten Verfahrens automatisch aus dem an Hand der Figur 3A erläuterten Entwurf erzeugt worden ist. Den Geraden 92, 94 und 96 im Entwurf 90 entsprechen im Entwurf 110 Linien 114, 116 und 118. Im Entwurf 110 gibt es am rechten Ende der Linien 114 und 118 eine Einengung 112. Die Einengung 112 wird durch die symmetrisch zueinander verlaufenden Linien 114 und 118 gebildet und hat stufenförmige Enden. Die Einengung 112 hat an ihrer schmalsten Stelle eine Breite B7, die mit dem Durchmesser D2 des Kreises 98 übereinstimmt. Eine Länge L4 der Einengung 112 beträgt etwa das Eineinhalbfache des Durchmessers D2. Die Lage des Kreises 98 im Entwurf 110 ist zur Lage des Kreises 98 im Entwurf 90 unverändert geblieben. Das bedeutet, dass die durch die Gerade 94 festgelegte Stirnseite der Leitbahn etwas entgegengesetzt der x-Richtung 52 versetzt worden ist.

Während es bei einer mit Hilfe des Entwurfs 90 hergestellten integrierten Schaltungsanordnung keine Berührungsbereiche zwischen dem Leitbahn-Liner und dem Via-Liner gibt, gibt es bei einer mit Hilfe des Entwurfs 110 erzeugten Leibahn-Via-Anordnung drei Berührungsbereiche von Via-Liner und Leitbahn-Liner. Den Berührungsbereichen entsprechen im Entwurf 110 Überlappungsbereiche 122, 124 und 126 des Kreises 98 mit einer gestrichelten Linie 120, die der Linie 100 entspricht und die die Lage des Leitbahn-Liners darstellt.

Figur 3C zeigt einen Entwurf 130, der bei Anwendung einer alternativen Regel mit Hilfe des unten an Hand der Figur 8 erläuterten Verfahrens aus dem an Hand der Figur 3A erläuterten Entwurf 90 erzeugt worden ist. Die Lage des Kreises 98 und sein Durchmesser D2 sind unverändert geblieben. Jedoch wurde an den Geraden 92 bis 96 entsprechenden Linien 134, 136 und 138 eine Einengung 132 erzeugt. Die Einengung 132 hat einen keilförmigen Abschnitt mit einer Länge L5. Im Bereich des Kreises 98 werden die Linien 134 und 138 parallel zueinander auf einer Länge L6 geführt, bis die gerade Linie 136 erreicht ist. Der Wert der Länge L6 ist etwa ein Fünftel größer als der Wert des Durchmessers D2. Die Länge L5 ist etwa halb so groß wie der Durchmesser D2 des Kreises 98. Eine Breite B8 der Einengung 132 an ihrer schmalsten Stelle ist gleich dem Durchmesser D2.

Auch bei einer mit Hilfe des Entwurfs 130 erzeugten Leitbahn-Via-Anordnung entstehen drei Berührungsbereiche in Überlappungsbereichen 140, 142 und 144 des Kreises 98 mit einer die Lage des Leitbahn-Liners andeutenden gestrichelten Linie 146.

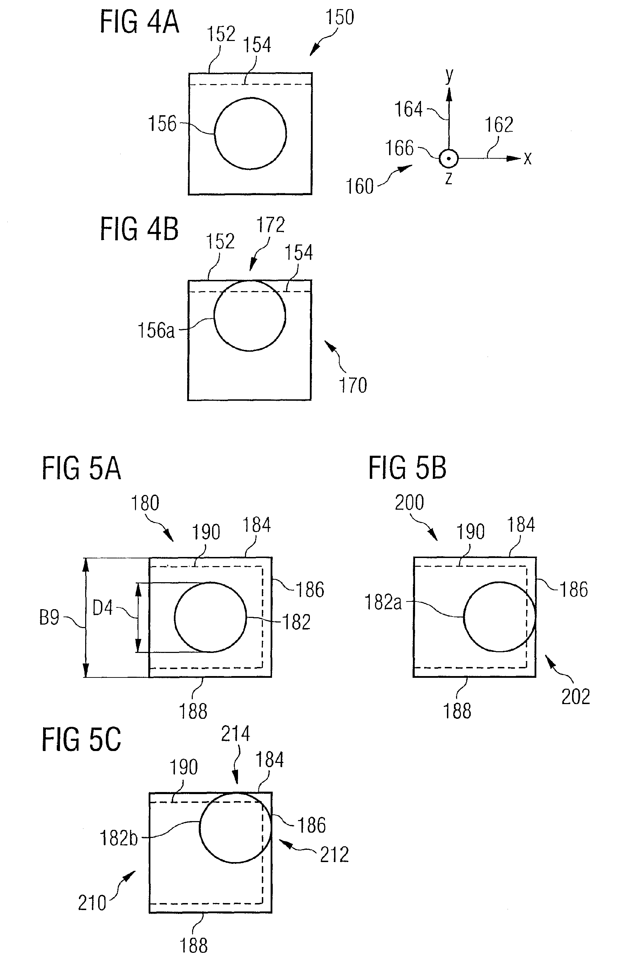

Figur 4A zeigt einen Entwurf 150 mit einer Geraden 152, die letztlich die Lage des Randes eines Grabens für eine Leitbahn vorgibt. Eine gestrichelte Geraden 154 verdeutlicht die Lage eines Leitbahn-Liners. Ein Kreis 156 gehört zu einer anderen Entwurfsebene und gibt die Lage eines zu der Leitbahn führenden Kontaktloches vor. Der Kreis 156 hat einen Abstand zur Geraden 152, bei dem keine Überlappung des Kreises 156 mit der Geraden 152 oder mit der Geraden 154 auftritt.

Für die Figuren 4A bis 7 gilt ein Koordinatensystem 160 mit einer x-Achse 162, einer y-Achse 164 und einer z-Achse 166. Bezüglich der Lage von Entwurfsebenen und Koordinatensystem 160 gilt das zum Koordinatensystem 50 Gesagte.

Figur 4B zeigt einen Entwurf 170, der aus dem Entwurf 150 mit Hilfe des unten an Hand der Figur 8 erläuterten Verfahrens automatisch erzeugt worden ist. Die Lage der Linien 152 und 154 hat sich nicht verändert. Dagegen ist ein Kreis 156a im Vergleich zum Kreis 156 in y-Richtung so versetzt worden, dass sein Rand eine größte y-Koordinate hat, die mit der y-Koordinate der Linie 152 übereinstimmt. Aufgrund des versetzten Kreises 156a gibt es einen Überlappungsbereich 172, an dem der Kreis 156a den Zwischenraum zwischen der Geraden 152 und der gestrichelten Geraden 154 überlappt. Diese Überlappung führt bei einer gemäß dem Entwurf 170 hergestellten Leitbahn-Kontaktlochanordnung zu einer Überlappung des Leitbahn-Liners mit dem Via-Liner.

Figur 5A zeigt einen Entwurf 180 für die Anordnung eines durch einen Kreis 182 dargestellten Kontaktloches am Ende eines durch U-förmig angeordnete Geraden 184, 186 und 188 gebildeten Musters. Der Kreis 182 befindet sich in der Mitte eines von den Geraden 184 bis 188 umschlossenen Bereiches und hat einen Durchmesser D4, der etwa um ein Drittel kleiner ist als eine dem Abstand der parallel zueinander verlaufenden Geraden 184 und 188 entsprechende Breite B9 des Musters. Im Entwurf 180 gibt es keine Überlappungsbereiche zwischen dem Kreis 182 und einer die Lage des Leitbahn-Liners darstellenden gestrichelten Linie 190.

Figur 5B zeigt einen aus dem Entwurf 180 automatisch erzeugten Entwurf 200. Die Lage der Linien 184 bis 188 ist unverändert geblieben. Jedoch wurde der Kreis 182 in x-Richtung versetzt, so dass ein Kreis 182a entstanden ist. Die größte x-Koordinate des Kreises 182a stimmt mit der x-Koordinate der Gerade 186 überein, die die Lage der Stirnseite des Musters angibt. Es entsteht ein Überlappungsbereich 202 zwischen dem Kreis 182a und dem zwischen der gestrichelten Linie 190 und der Geraden 186 liegenden Bereich.

Figur 5C zeigt einen Entwurf 210, der bei einem alternativen Verfahren automatisch aus dem Entwurf 180 erzeugt worden ist. Die Lage der Geraden 184, 186 und 188 ist unverändert geblieben. Jedoch wurde der Kreis 182 sowohl in x-Richtung als auch in y-Richtung versetzt, so dass ein Kreis 182b entstanden ist. Die größte x-Koordinate des Kreises 182b stimmt mit der x-Koordinate der Geraden 186 überein. Die größte y-Koordinate des Kreises 182b stimmt mit der y-Koordinate der Geraden 184 überein. Dadurch gibt es zwei Überlappungsbereiche 212 und 214 zwischen dem Kreis 182b und dem zwischen der Linie 190 und der Geraden 184 bzw. der Geraden 186 liegenden Bereich. Der Entwurf 214 wurde beispielsweise durch aufeinanderfolgendes Anwenden von Regeln zur Verschiebung des Kreises 182 in x-Richtung und in y-Richtung erzeugt.

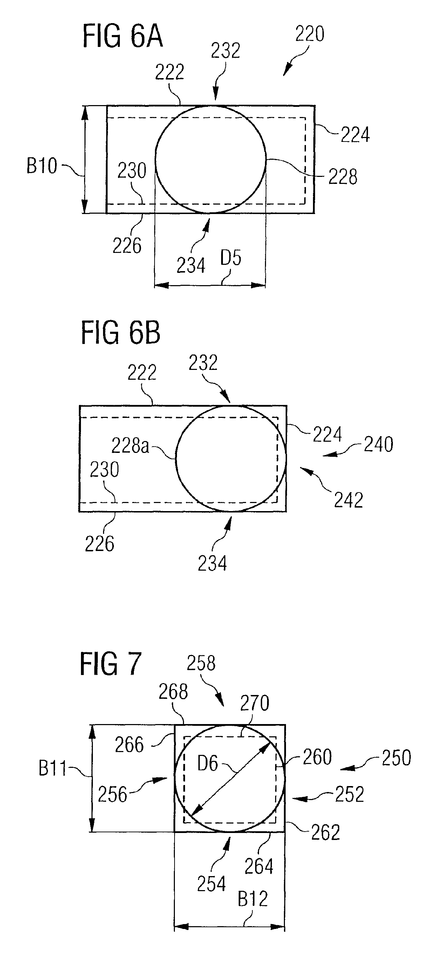

Figur 6A zeigt einen Entwurf 220, der U-förmig angeordnete Geraden 222, 224 und 226 enthält, die letztlich die Lage des Randes eines Grabens für eine Leitbahn vorgeben. Ein Abstand zwischen den parallel zueinander liegenden Geraden 222 und 226 legt eine Breite B10 des durch die Geraden 222, 224 und 226 gebildeten Musters fest. Außerdem enthält der Entwurf 220 einen Kreis 228, der letztlich die Lage eines Kontaktloches vorgibt. Eine gestrichelte Linie 230 zeigt die Lage eines Leitbahn-Liners bzgl. des Entwurfs 220. Im Entwurf 220 gibt es bereits zwei Überlappungsbereiche 232 und 234, in denen der Kreis 228 den Bereich zwischen der Linie 222 und der gestrichelten Linie 230 bzw. zwischen der Linie 226 und der gestrichelten Linie 230 überlappt. Der Kreis 232 hat einen Durchmesser D5, der gleich der Breite B10 ist. Am Ende des durch die Geraden 222 bis 226 gebildeten Musters, d.h. im Bereich der Geraden 224 gibt es dagegen keinen Überlappungsbereich.

Figur 6B zeigt einen aus dem Entwurf 220 automatisch erzeugten Entwurf 240. Die Lage der Geraden 222 bis 226 ist unverändert geblieben. Jedoch wurde der Kreis 228 in x-Richtung versetzt, wobei ein Kreis 228a entstanden ist. Die größte x-Koordinate des Kreises 228a stimmt mit der x-Koordinate der Geraden 224 überein. Demzufolge gibt es zusätzlich zu den Überlappungsbereichen 232 und 234 im Entwurf 240 einen dritten Überlappungsbereich 242 an der Stirnseite des durch die Geraden 222 bis 226 dargestellten Grabens. Die Anzahl der Überlappungsbereiche wurde also durch die Anwendung des automatischen Verfahrens erhöht.

Figur 7 zeigt einen Entwurf 250, bei dem es vier Überlappungsbereiche 252, 254, 256 und 258 eines Kreises 260 mit Bereichen zwischen den ein Quadrat bildenden Geraden 262, 264, 266 und 268 und einer gestrichelten Linie 270 gibt. Der Kreis 260 hat einen Durchmesser D6. Das Quadrat hat eine Seitenlänge B11 bzw. B12, die gleich dem Durchmesser D6 ist.

Der Entwurf 250 wurde ebenfalls automatisch mit Hilfe des unten an Hand der Figur 8 erläuterten Verfahrens erzeugt. Dabei wurde der Abstand zwischen den Geraden 252 und 256 bzw. zwischen den Geraden 254 und 258 verkleinert.

Figur 8 zeigt Verfahrensschritte eines Verfahrens zum gezielten Erhöhen der Anzahl von Berührungsstellen von Via-Liner und Leitbahn-Liner in einer integrierten Schaltungsanordnung. Das Verfahren beginnt in einem Verfahrensschritt 300. In einem folgenden Verfahrensschritt 302 werden Entwurfsdaten vorgegeben, die beispielsweise gemäß einem standardisierten Datenformat gespeichert sind, z.B. gemäß dem Format GDSII (Graphic Design System), da z.B. von dem Programm Cadence Framework genutzt wird. Die Entwurfsdaten sind in einer Datei gespeichert und geben ein Bitmuster oder eine Vektorgrafik für verschiedene Entwurfsebenen vor.

In einem Verfahrensschritt 304 werden Regeln vorgegeben, nach denen die Entwurfsdaten geändert werden sollen. Die Regeln werden beispielsweise in einem Programm hinterlegt, das nach Art eines Bildbearbeitungsprogramms die geometrischen Muster des Entwurfs ändert.

In einem Verfahrensschritt 306 wird eine erste Kontaktstelle zwischen einem Via und einer Leitbahn ermittelt, die durch die Entwurfsdaten vorgegeben wird. In einem folgenden Verfahrensschritt 308 wird geprüft, ob für eine ermittelte Kontaktstelle eine Veränderung gemäß den vorgegebenen Regeln möglich ist, d.h. im Ausführungsbeispiel:
- ob eine Einengung einer Leitbahn möglich ist, oder
- ob ein Versatz eines Kontaktloches für ein Via oder ein Versatz einer Leitbahn möglich sind.

Im Ausführungsbeispiel wird zunächst geprüft, ob eine Einschnürung möglich ist. Ist dies der Fall, so werden in einem dem Verfahrensschritt 308 unmittelbar folgenden Verfahrensschritt 310 die Entwurfsdaten entsprechend geändert. In einem folgenden Verfahrensschritt 312 wird geprüft, ob an der ermittelten Kontaktstelle eine weitere Regel zu einer Erhöhung der Anzahl der Überlappungsbereiche bzw. schließlich der Berührungsbereiche führt. Ist dies der Fall, so wird das Verfahren mit dem Verfahrensschritt 308 fortgesetzt. Das Verfahren befindet sich nun in einer Schleife aus den Verfahrensschritten 308 bis 312. Diese Schleife wird im Verfahrensschritt 312 erst dann verlassen, wenn festgestellt wird, dass es keine weitere Regel mehr gibt, die gemäß den vorgegebenen Regeln zu einer Verbesserung des Entwurfs für die ermittelte Kontaktstelle führen könnte. In diesem Fall folgt unmittelbar nach dem Verfahrensschritt 312 ein Verfahrensschritt 314.

Der Verfahrensschritt 314 folgt auch unmittelbar nach dem Verfahrensschritt 308, wenn in diesem Verfahrensschritt 308 festgestellt wird, dass keine Veränderung gemäß einer Regel möglich ist.

Im Verfahrensschritt 314 wird geprüft, ob es weitere unbearbeitete Kontaktstellen gemäß den ursprünglichen Entwurfsdaten gibt. Ist dies der Fall, so folgt unmittelbar nach dem Verfahrensschritt 314 wieder der Verfahrensschritt 306. Damit befindet sich das Verfahren in einer Verfahrensschleife aus den Verfahrensschritten 306 bis 314. Beim Ausführen der Verfahrensschritte 308 bis 314 in dieser Verfahrensschleife werden nach und nach alle Kontaktstellen des Entwurfs geprüft und gegebenenfalls die Entwurfsdaten für die Kontaktstellen gemäß der vorgegebenen Regeln geändert. Die Schleife aus den Verfahrensschritten 308 bis 314 wird im Verfahrensschritt 314 erst dann verlassen, wenn es keine weiteren Kontaktstellen gemäß dem Entwurf gibt, die noch nicht geprüft und gegebenenfalls geändert worden sind. In diesem Fall folgt unmittelbar nach dem Verfahrensschritt 314 ein Verfahrensschritt 316.

Im Verfahrensschritt 316 werden die geänderten Entwurfsdaten in einer Datei gespeichert und stehen so für die weitere Bearbeitung zur Verfügung, beispielsweise für die Herstellung von Masken zur Herstellung der integrierten Schaltungsanordnung. Alternativ oder zusätzlich werden die geänderten Entwurfsdaten ausgegeben, beispielsweise als grafische Darstellung auf einem Bildschirm. Ein Entwickler hat nun die Möglichkeit, Stichproben der durchgeführten Änderungen zu prüfen. Das Verfahren wird in einem Verfahrensschritt 318 beendet.

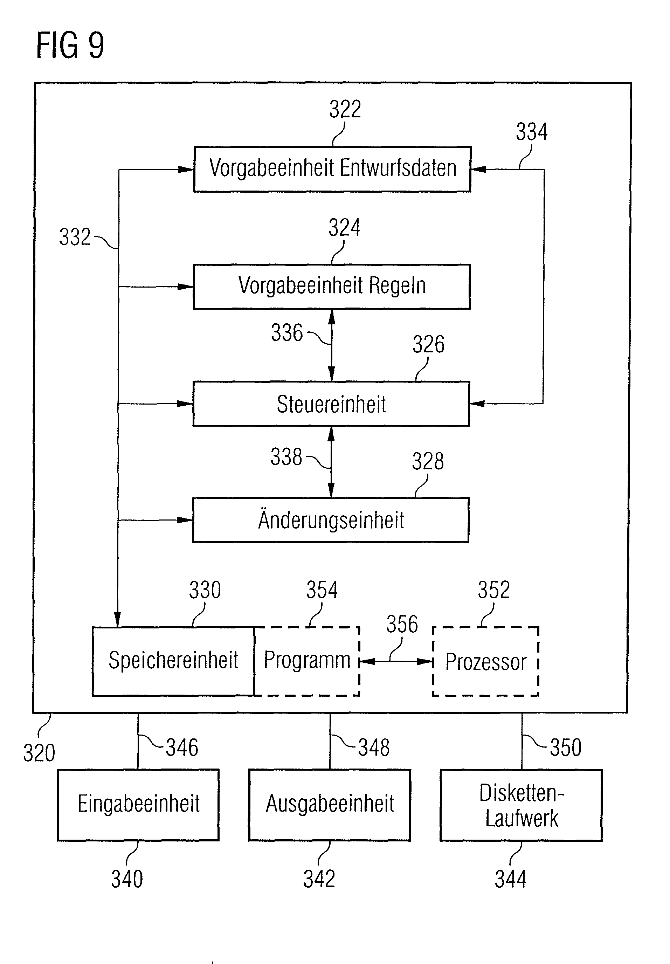

Figur 9 zeigt eine Vorrichtung 320 zum Ausführen der an Hand der Figur 8 erläuterten Verfahrensschritte 300 bis 318. Die Vorrichtung 320 enthält eine Vorgabeeinheit 322 für Entwurfsdaten, eine Vorgabeeinheit 324 für die Regeln, eine Steuereinheit 326, eine Änderungseinheit 328 und eine Speichereinheit 330, z.B. einen RAM (Random Access Memory). Die Vorgabeeinheiten 322 und 324, die Steuereinheit 326 und die Änderungseinheit 328 greifen über einen Speicherbus 332 auf die Speichereinheit 330 zu. Die Steuereinheit 326 steuert die Vorgänge in der Vorgabeeinheit 322, in der Vorgabeeinheit 324 und in der Änderungseinheit 328, siehe Pfeile 334 bis 338.

Die Vorgabeeinheit 322 dient zum Vorgeben der Entwurfsdaten, d.h. zum Ausführen des Verfahrensschrittes 302. Die Vorgabeeinheit 324 dient zum Hinterlegen von Regeln, d.h. zum Ausführen des Verfahrensschrittes 304. Die Änderungseinheit 328 dient zum Ändern der Entwurfsdaten gemäß der durch die Vorgabeeinheit 324 vorgegebenen Regeln.

An der Vorrichtung 320 sind außerdem eine Eingabeeinheit 340, z.B. eine Tastatur, eine Ausgabeeinheit 342, z.B. ein Bildschirm, und ein Diskettenlaufwerk 344 über eine Leitung 346, 348 bzw. 350 angeschlossen.

Bei einem Ausführungsbeispiel werden die Funktionen der Einheiten 322 bis 328 durch elektronische Schaltwerke erbracht, die keinen Prozessor enthalten. Bei einem alternativen Ausführungsbeispiel werden die Funktionen der Einheiten 322 bis 328 mit Hilfe eines Prozessors 352 erbracht, der ein Programm in einer Programmspeichereinheit 354 abarbeitet, siehe Pfeil 356.

## Patentansprüche

1. Integrierte Schaltungsanordnung (10),
mit mindestens einer Metallisierungslage (16), die eine Vielzahl elektrisch leitender Leitbahnen (14) enthält,
mit einem Leitbahndielektrikum (18) zwischen den Leitbahnen (14),
mit jeweils zwischen einer Seitenfläche (40) einer Leitbahn (14) und dem Leitbahndielektrikum (18) angeordneten elektrisch leitfähigem Leitbahn-Zwischenmaterial (20),
mit einer Vielzahl elektrisch leitender Verbindungsabschnitte (12), die jeweils einen Abschnitt einer elektrisch leitfähigen Verbindung zu oder von einer Leitbahn (14) bilden,
mit einem Verbindungsabschnittsdielektrikum (24) zwischen den Verbindungsabschnitten (12),
wobei die Metallisierungslage (16) unter den Verbindungsabschnitten (12) liegt,
mit jeweils zwischen einem Verbindungsabschnitt (12) und dem Verbindungsabschnittsdielektrikum (24) und/oder zwischen einem Verbindungsabschnitt (12) und einer Leitbahn (14) angeordnetem Verbindungsabschnitts-Zwischenmaterial (28),
wobei an mindestens einer Verbindung das Leitbahn-Zwischenmaterial (20) und das Verbindungsabschnitts-Zwischenmaterial (28) einander berühren.

2. Schaltungsanordnung (10) nach Anspruch 1, **dadurch gekennzeichnet, dass** sich an der Verbindung das Leitbahn-Zwischenmaterial (20) und das Verbindungsabschnitts-Zwischenmaterial (28) an zwei Seitenflächen (40) einer Leitbahn (14) berühren.

3. Schaltungsanordnung (10) nach Anspruch 1, **dadurch gekennzeichnet, dass** sich an der Verbindung das Leitbahn-Zwischenmaterial (20) und das Verbindungsabschnitts-Zwischenmaterial (28) an drei Seitenflächen (40) einer Leitbahn (14) berühren.

4. Schaltungsanordnung (10) nach Anspruch 1, **dadurch gekennzeichnet, dass** sich an der Verbindung das Leitbahn-Zwischenmaterial (20) und das Verbindungsabschnitts-Zwischenmaterial (28) an vier Seitenflächen (40) einer Leitbahn (14) berühren.

5. Schaltungsanordnung (10) nach einem der vorhergehenden Ansprüche, **dadurch gekennzeichnet, dass** sich das Leitbahn-Zwischenmaterial (20) und das Verbindungsabschnitts-Zwischenmaterial (28) an einer durch die Berührungslinie zweier Flächen der Leitbahn (14) gebildeten Kante (42) berühren.

6. Schaltungsanordnung (10) nach Anspruch 1 oder 2, **dadurch gekennzeichnet, dass** mindestens zwei Abschnitte derselben Leitbahn (14) oder von verschiedenen Leitbahnen an Verbindungsabschnitten (12) breiter sind als die Verbindungsabschnitte (12),
und dass die Berührungsbereiche an solchen Seitenflächen der Abschnitte liegen, deren Normalenrichtung quer oder entgegengesetzt zueinander liegen.

7. Schaltungsanordnung (10) nach einem der vorhergehenden Ansprüche, **dadurch gekennzeichnet, dass** die Leitbahn (14) aus Kupfer oder einer Kupferlegierung besteht, die mindestens fünfundneunzig Prozent Kupfer enthält, und/oder dass die Leitbahn (14) aus Aluminium oder einer Aluminiumlegierung besteht, die mindestens fünfundneunzig Prozent Aluminium enthält,
und/oder dass das Leitbahndielektrikum (18) und/oder das Verbindungsabschnittsdielektrikum ein Oxid, vorzugsweise Siliziumdioxid, oder ein Dielektrikum mit einer Dielektrizitätskonstante kleiner als 3,9 enthält,
und/oder dass das Leitbahn-Zwischenmaterial (20) und/oder das Verbindungsabschnitts-Zwischenmaterial (28) ein Nitrid enthält, vorzugsweise aus einem Nitrid besteht, insbesondere aus einem Metallnitrid,
und/oder das das Leitbahnzwischenmaterial ein Refraktärmetall enthält oder aus einem Refraktärmetall besteht, vorzugsweise aus Tantal,
und/oder dass die Verbindungsabschnitte (12) Wolfram enthalten, vorzugsweise aus Wolfram bestehen, oder das die Verbindungsabschnitte (12) Kupfer enthalten oder aus Kupfer bestehen.

8. Schaltungsanordnung (10) nach einem der vorhergehenden Ansprüche, **dadurch gekennzeichnet, dass** die einem Verbindungsabschnitt (12) benachbarte Fläche einer Leitbahn (14) im wesentlichen frei und/oder zu mehr als achtzig Prozent frei von einem elektrisch leitfähigem Zwischenmaterial ist.

9. Schaltungsanordnung (10) nach einem der vorhergehenden Ansprüche, **dadurch gekennzeichnet, dass** die Schaltungsanordnung (10) mittels einer Damascene-Technik oder mittels einer dualen Damascene-Technik gefertigt worden ist.
